# EUROPÄISCHE PATENTANMELDUNG

(11) **EP 1 156 708 A2**
(43) Veröffentlichungstag der Anmeldung: **21.11.2001**
(21) Anmeldenummer: 01111146.5
(22) Anmeldetag: 10.05.2001
(51) Int. Cl.: H05K 3/10, H05K 3/04, H05K 3/46, H05K 1/02

(54) **Leiterplatte sowie Verfahren zur Herstellung einer Leiterplatte**

(30) Priorität: 15.05.2000 DE 10023736
(71) Anmelder: Harting Elektro-optische Bauteile GmbH & Co. KG., 31162 Bad Salzdetfurth (DE)
(72) Erfinder: Kragl, Hans, Dr., 31199 Diekholzen (DE); Hohmann, Rolf, 31162 Bad Salzdetfurth (DE)
(74) Vertreter: Sties, Jochen, Dipl.-Ing.

(57) **Zusammenfassung**

Es wird eine Leiterplatte (5) beschrieben, die aus mindestens zwei in Abformtechnik hergestellten Leiterplatten-Einzellagen (10) aus Kunststoff besteht, die jeweils eine erste und eine zweite Funktionsseite aufweisen sowie mindestens eine mikrostrukturierte Positioniergestaltung (16) auf der ersten und auf der zweiten Funktionsseite und mindestens einen mikrostrukturierten, mit einer Metallisierung (18) versehenen Leitergraben (12) auf einer der Funktionsseiten. Auf diese Weise ist mit geringem Aufwand die Herstellung von Leiterplatten mit hoher Packungsdichte möglich.

## Beschreibung

Die Erfindung betrifft eine Leiterplatte sowie ein Verfahren zu ihrer Herstellung.

Leiterplatten werden derzeit durch präzises Aufeinanderlaminieren von mehreren, zweiseitig photolithographisch strukturierten Einzellagen hergestellt. Das Ausgangsmaterial für die Einzellagen ist eine verstärkte oder unverstärkte Folie bzw. Platte aus Epoxydharzmaterial, die als Halbzeug in unstrukturierter Form im allgemeinen schon mit dünner Kupferschicht versehen ist. Da nach dem Laminieren die Durchkontaktierung durch das Anbringen von Bohrungen erfolgt, müssen die Einzellagen sehr präzise übereinander geschichtet werden, so daß ein Bohrwerkzeug die zu verbindenden Kontakte zuverlässig trifft. Alternativ können als Positioniergestaltungen auch Bohrungen verwendet werden, die mit der erforderlichen hohen Präzision korrekt ausgerichtet relativ zu den Leiterbahnen hergestellt werden. Da dies aber für jede Einzellage mit sehr hoher Präzision und somit hohem Aufwand erforderlich ist, ist die Leiterplattenherstellung teuer.

Bei dieser Technik ist die Montage von Bauteilen nur auf der Ober- oder der Unterseite der mehrlagigen Leiterplatte möglich. Es kann sich um mit einem Gehäuse versehene oder als Chip vorliegende, aktive Halbleiterbauteile oder um passive Bauteile handeln. Diese Bauteile können nicht auf den inneren Lagen der Leiterplatte angebracht werden, da zwischen den Lagen kein Platz, etwa in Form einer Aufnahmeöffnung, vorgesehen werden kann. Daher steigt der Verdrahtungsaufwand, und die Leiterplatte wird durch zusätzlich notwendige Zwischenlagen komplex , großvolumiger und teurer.

Eine Hochfrequenz-Leitung wird bei den heutigen Leiterplatten durch zwei parallel verlaufende, elektrische Einzelleiter auf einer Lagenebene realisiert. Dabei wird das elektrische Feld notwendigerweise zwischen beiden Leitern im Leiterplattenmaterial geführt. Das Leiterplattenmaterial bekommt dadurch mit seinen dielektrischen Materialeigenschaften einen wesentlichen Einfluß auf die Übertragungseigenschaften der HF-Leitung. Mit steigenden Frequenzen sind Standardmaterialien wie FR4 nicht mehr geeignet, weshalb keramische Träger oder fluorierte Kunststoffe (Teflon) verwendet werden, welche dann bis zu höheren Frequenzen geeignet sind. Diese Materialien sind jedoch teuer und haben ebenfalls eine maximale Frequenz, jenseits derer die HF-Leitung materialbedingt zu stark gedämpft wird.

Bei den herkömmlichen Leiterplatten könnten auch optische Zwischenlagen mit dielektrischen Wellenleitern integriert werden. Jedoch muß zur Ein- und Auskopplung des Lichtes eine präzise Positionierung zwischen den verschiedenen Lagen vorgenommen werden. Dies ist nicht machbar, da das Ausgangsmaterial plattenförmig und unstrukturiert ist und die Strukturierung der Kupferfolie zur Positionierung von Halbleiterchips und Platten zueinander nicht geeignet ist.

Zur Abfuhr großer Verlustwärmemengen können die bekannten Leiterplatten auch mit einem integrierten, fluidischen Kühlsystem versehen werden. Die Kühlkanäle müssen jedoch in separaten Arbeitsgängen hergestellt werden. Dies macht die Leiterplatte teuer.

Da die Taktrate der Informationsverarbeitungssysteme, bei denen die bekannten Leiterplatten verwendet werden, weiter ansteigt, steigen auch die Anforderungen an die Kompaktheit der Leiterplatte, an die Übertragungsfrequenz der HF-Leiter, an die abzuführende thermische Verlustleistung sowie an die Präzision der elektrischen Leiter. Weiterhin wird sich der Bedarf ergeben, in die Leiterplatte optische Leiter zu integrieren, wobei die Ein- und Auskopplung von Licht mit geringem Aufwand möglich sein muß. Nachteilig bei den bekannten Leiterplatten ist, daß eine Verbesserung des HF-Verhaltens, eine Integration von optischen Wellenleitern und fluidischen Kühlsystemen sowie eine Vergrößerung der Packungsdichte nur mit extrem hohem Aufwand möglich ist.

Die Aufgabe der Erfindung besteht darin, eine Leiterplatte zu schaffen, welche die Voraussetzungen für eine hohe Packungsdichte, eine gute HF-Leitung, ein einfach auszubildendes Kühlsystem sowie die Verwendung von optischen Wellenleitern schafft.

Diese Aufgabe wird gelöst durch eine Leiterplatte bestehend aus mindestens zwei in Abformtechnik hergestellten Leiterplatten-Einzellagen aus Kunststoff, die jeweils eine erste und eine zweite Funktionsseite aufweisen sowie mindestens eine mikrostrukturierte Positioniergestaltung auf der ersten und auf der zweiten Funktionsseite und mindestens einen mikrostrukturierten, mit einer Metallisierung versehenen Leitergraben auf einer der Funktionsseiten. Durch die Verwendung eines Abformverfahrens zur Herstellung der Einzellagen, insbesondere eines Spritzgußverfahrens, können die für die gewünschten Funktionen der Leiterplatte erforderlichen Gestaltungen mit geringem Aufwand und höchster Präzision bereits bei der Herstellung der Einzellagen ausgebildet werden; es ist kein nachfolgender Bearbeitungsschritt, etwa ein spanendes Nachbearbeiten, erforderlich, um geometrische Strukturen mit hoher Lagegenauigkeit auszubilden. Da auch die Positioniergestaltungen bereits bei der Herstellung der Einzellagen abgeformt werden, ist ihre Anordnung relativ zu Mikrostrukturen, die auf den Funktionsseiten angeordnet sind und spezielle Funktionen haben, präzise vorgegeben, so daß sämtliche Mikrostrukturen der Einzellagen später präzise zueinander ausgerichtet sind.

Für die Positioniergestaltungen können gemäß einer Ausführungsform der Erfindung Vorsprünge und Vertiefungen verwendet werden, die beispielsweise pyramidenförmig sind. Wenn die Einzellagen aufeinandergesetzt werden, um die Leiterplatte zu bilden, greifen die Vorsprünge der einen Einzellage in die Vertiefungen der anderen Einzellage ein, so daß sich eine automatische Ausrichtung der Einzellagen relativ zueinander ergibt.

Gemäß einer alternativen Ausführungsform der Erfindung können für die Positioniergestaltungen Öffnungen verwendet werden, die sich von der einen Funktionsseite durch die Einzellage hindurch bis auf die andere Funktionsseite erstrecken. Durch diese Öffnungen kann dann ein Positionierstift gesteckt werden, so daß die Einzellagen relativ zueinander präzise positioniert sind.

Gemäß einer Ausführungsform der Erfindung ist vorgesehen, daß der Leitergraben sich bis zum Rand der Leiterplatte erstreckt, so daß ein Steckverbinder angeschlossen werden kann. Dieser Steckverbinder kann entweder auf die gesamte Leiterplatte aufgesteckt werden oder, falls sich dies als zweckmäßig erweist, nur auf einige der Einzellagen, die zu diesem Zweck mit einem von der Leiterplatte abstehenden Anschlußvorsprung versehen sind, bis auf den sich dann die entsprechenden Leitergräben erstrecken.

Zur Erzielung einer HF-Leitung ist gemäß einer Ausführungsform der Erfindung ein erster Leitergraben auf einer der Einzellagen und ein zweiter Leitergraben auf der anderen Einzellage vorgesehen, wobei die beiden Leitergräben einander zentriert gegenüberliegen und einer der Leitergräben kleinere Abmessungen hat als der andere Leitergraben. Der Leitergraben mit den größeren Abmessungen kann beispielsweise einen halbkreisförmigen oder rechteckigen Querschnitt haben, so daß er den Leitergraben mit den kleineren Abmessungen überspannt, wobei der Raum zwischen den einander gegenüberliegenden Leitergräben mit Luft gefüllt ist. Auf diese Weise ist ein HF-Leiter gebildet, der "zwischen" den Einzellagen der Leiterplatte angeordnet ist. Das elektrische und magnetische Wechselfeld wird in dem umschlossenen Hohlraum aus Luft geführt, so daß die Materialeigenschaften des Kunststoffs der Einzellagen keinen Einfluß auf die HF-Leitung haben.

Zur Kühlung der Leiterplatte ist gemäß einer Ausführungsform der Erfindung auf mindestens einer der Einzellagen eine Kühlnut vorgesehen, die mit einer Metallisierung solcher Dicke gefüllt ist, daß ein Kühlkörper gebildet ist. Dieser Kühlkörper ermöglicht es, die Verlustwärme von auf der Leiterplatte angeordneten Bauteilen durch Wärmeleitung abzuführen.

Zur Kühlung der Leiterplatte kann gemäß einer anderen Ausführungsform der Erfindung auf mindestens einer der Einzellagen ein Kühlkanal vorgesehen sein, durch den ein Kühlmittel geleitet werden kann, wobei die andere Einzellage den Kühlkanal abdeckt. Auch der Kühlkanal stellt eine Mikrostruktur dar, die ohne großen Aufwand beim Abformen der Einzellage ausgebildet werden kann. Mittels des Kühlkanals kann eine aktive Kühlung der Leiterplatte erzielt werden, mit der auch sehr große Verlustwärmemengen abgeführt werden können.

Der Kühlkanal erstreckt sich vorzugsweise bis zum Rand der Leiterplatte, wobei an der Leiterplatte ein Kühlmittel-Anschluß gebildet ist, mittels dem der Kühlkanal in einfacher Weise an eine externe Kühlvorrichtung angeschlossen werden kann, welche die Versorgung mit dem Kühlmittel gewährleistet.

Gemäß einer weiteren bevorzugten Ausführungsform der Erfindung ist in mindestens einer der Einzellagen mindestens eine Aufnahme für ein elektronisches, optisches oder opto-elektronisches Bauteil vorgesehen. Auch die Aufnahme stellt eine Mikrostruktur dar, die bei der Herstellung einfach mit hoher Genauigkeit abgeformt werden kann, so daß die Bauteile genau an der richtigen Stelle im Inneren der Leiterplatte angeordnet werden können, was den Aufwand für das Anschließen der Bauteile verringert. Bei Bedarf kann eine der Aufnahme gegenüberliegende Aussparung in der anderen Einzellage vorgesehen sein. Diese Aussparung gewährleistet beispielsweise, daß die zum Anschließen des Bauteils verwendeten Bonddrähte nicht beschädigt werden.

Die Einzellagen der Leiterplatte können miteinander durch ein elektrisch leitendes Material verbunden sein, beispielsweise durch einen elektrisch leitenden Klebstoff. Auf diese Weise ist eine Kontaktierung von Leitergräben, die auf unterschiedlichen Leiterplatten angeordnet sind, möglich. Zur Kontaktierung von Leitergräben, die auf voneinander abgewandten Funktionsseiten der Einzellagen angeordnet sind, können Kontaktöffnungen verwendet werden, die sich von der ersten Funktionsseite einer Einzellage durch diese hindurch zur zweiten Funktionsseite erstrecken und mit einem elektrisch leitenden Material gefüllt sind.

Gemäß einer weiteren bevorzugten Ausführungsform der Erfindung ist vorgesehen, daß mindestens eine der Einzellagen aus einem optisch transparenten Material besteht und daß auf dieser Einzellage ein Wellenleitergraben vorgesehen ist, der mit einem optisch transparenten Material gefüllt ist, dessen Brechungsindex sich geeignet von demjenigen des Materials der Einzellage unterscheidet, so daß ein Wellenleiter gebildet ist. Auch die für die Herstellung des Wellenleiters erforderliche Mikrostruktur der Einzellage kann mit geringem Aufwand beim Abformen der Einzellagen hergestellt werden. Anschließend ist lediglich erforderlich, ein geeignetes Material in den Wellenleitergraben einzubringen. Mit dem Wellenleiter können dann opto-elektronischen Bauteile zusammenwirken, die geeignet in den Aufnahmen der Einzellagen angeordnet werden können. Aufgrund der präzisen Anordnung der Aufnahmen relativ zum Wellenleiter ist eine gute optische Kopplung zwischen den in den Aufnahmen angeordneten Bauteilen und dem Wellenleiter zuverlässig zu erzielen.

Vorzugsweise ist vorgesehen, daß die mit dem Wellenleiter versehene Einzellage einen Spiegel aufweist, mittels dem Licht in den Wellenleiter eingekoppelt und aus diesem ausgekoppelt werden kann. Dies ermöglicht, ein opto-elektronisches Bauteil zu verwenden, das Licht in eine Richtung senkrecht zu der Ebene abstrahlt, in der sich der Wellenleiter erstreckt.

Vorzugsweise ist vorgesehen, daß der Spiegel ein separates Bauteil ist, das in die Einzellage eingesetzt wird. Dies verringert die Herstellungskosten, da der Spiegel und die Einzellage getrennt voneinander hergestellt werden können.

Die oben genannte Aufgabe wird auch durch ein Verfahren zum Herstellen einer Leiterplatte gelöst, welches die folgenden Schritte aufweist: Zunächst werden in Abformtechnik mindestens zwei Einzellagen-Rohlinge hergestellt, die jeweils auf einer ersten und einer zweiten Funktionsseite mit Positioniergestaltungen versehen sind. Die Einzellagen-Rohlinge werden dann auf ihrer gesamten Oberfläche so vorbehandelt, daß sie mit einer Metallisierung versehen werden können. Die Vorbehandlung kann beispielsweise darin bestehen, eine dünne Vor-Metallisierung aufzubringen oder das Substrat zu bekeimen. Anschließend wird die Oberfläche in den Bereichen, die nicht mit einer Metallisierung versehen werden sollen, nachbehandelt, so daß sich in diesen Bereichen keine Metallisierung abscheidet. Die Nachbehandlung kann beispielsweise darin bestehen, die Vor-Metallisierung mechanisch abzutragen oder die Bekeimung chemisch zu entfernen. Nachfolgend wird auf die nicht nachbehandelten Bereiche eine Metallisierung aufgebracht. Auf diese Weise werden Leiterbahnen auf der Leiterplatte gebildet. Abschließend werden die Einzellagen-Rohlinge aufeinandergesetzt, wobei sie mittels der Positioniergestaltungen relativ zueinander präzise positioniert werden. Auf diese Weise wird mit insgesamt geringem Herstellungsaufwand eine Leiterplatte erhalten, die hohe Anforderungen an die Präzision einhält. Das zugrundeliegende Prinzip besteht darin, den hohen Aufwand, der zur Erzielung der erforderlichen Präzision erforderlich ist, lediglich ein einziges Mal zu betreiben, nämlich bei der Herstellung der Form, von der die Einzellagen abgeformt werden. Wenn diese Form mit der erforderlichen Genauigkeit hergestellt ist, können die gewünschten geometrischen Mikrostrukturen, beispielsweise die Positioniergestaltungen, die Aufnahmen für Bauteile sowie die Kühlkanäle, ohne weiteren großen Aufwand abgeformt werden.

Vorteilhafte Ausgestaltungen der Erfindung ergeben sich aus den Unteransprüchen.

Die Erfindung wird nachfolgend unter Bezugnahme auf verschiedene Ausführungsformen beschrieben, die in den beigefügten Zeichnungen dargestellt sind. In diesen zeigen:
- Figur 1 in einer perspektivischen Ansicht eine erfindungsgemäße Leiterplatte;
- Figur 2 in einem Querschnitt einen Rohling einer Einzellage, die bei der in Figur 1 gezeigten Leiterplatte verwendet wird;
- Figur 3 den Einzellagen-Rohling von Figur 2 in einem ersten Bearbeitungszustand;
- Figur 4 den Einzellagen-Rohling von Figur 3 in einem zweiten Bearbeitungszustand;
- Figur 5 eine Leiterplatten-Einzellage, die bei der Leiterplatte von Figur 1 verwendet wird;
- Figur 6 in einem Schnitt ein Ausführungsbeispiel einer erfindungsgemäßen Leiterplatte;
- Figur 7 in einem Schnitt ein zweites Ausführungsbeispiel einer erfindungsgemäßen Leiterplatte;
- Figur 8 in einem Schnitt ein drittes Ausführungsbeispiel einer erfindungsgemäßen Leiterplatte;
- Figur 9 in einem Schnitt eine erfindungsgemäße Leiterplatte gemäß einer alternativen Ausführungsform während der Montage;
- Figur 10 in einer schematischen, geschnittenen Ansicht ein Detail einer erfindungsgemäßen Leiterplatte;
- Figur 11 in einer Ansicht entsprechend derjenigen von Figur 10 eine alternative Ausgestaltung;
- Figur 12 in einer schematischen Schnittansicht ein weiteres Detail einer erfindungsgemäßen Leiterplatte;
- Figur 13 in einer Ansicht entsprechend derjenigen von Figur 12 ein weiteres Detail einer erfindungsgemäßen Leiterplatte;
- die Figuren 14a bis 14c verschiedene Schritte bei der Herstellung einer Einzellage, die bei der in Figur 13 gezeigten Leiterplatte verwendet wird.

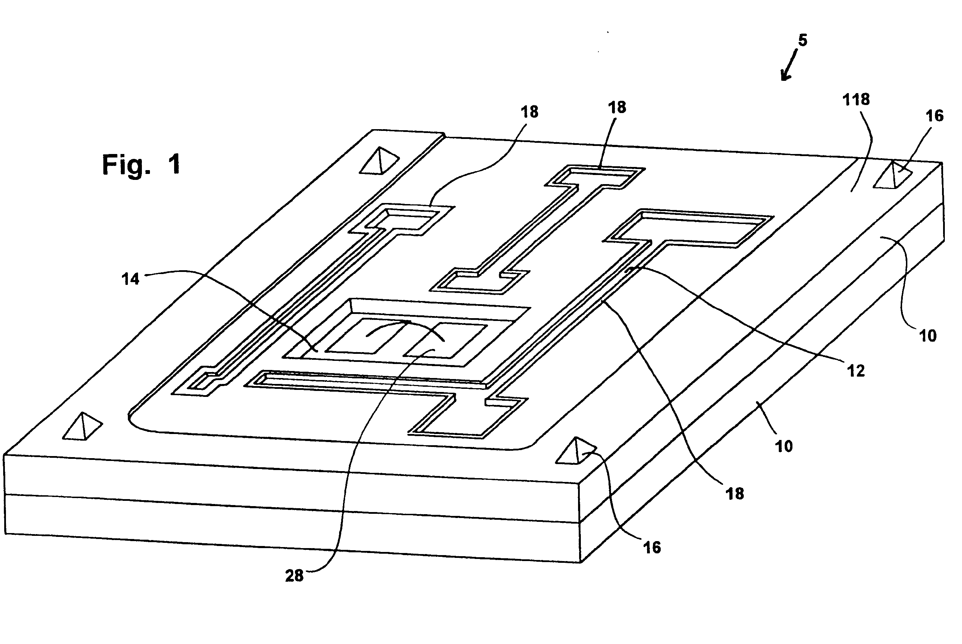

In Figur 1 ist ein Beispiel einer Leiterplatte 5 gezeigt. Sie besteht aus zwei Leiterplatten-Einzellagen 10, die aufeinandergesetzt sind. Jede Einzellage weist zwei Funktionsseiten auf, hier die Oberseite und die Unterseite, auf denen mikrostrukturierte geometrische Strukturen ausgebildet sind, die im Detail später erläutert werden. Bei der in Figur 1 gezeigten Leiterplatte sind auf der oberen Funktionsseite der oberen Einzellage 10 verschiedene Leitergräben 12 zu sehen, die mit einem elektrisch leitenden Material beschichtet sind, sowie eine Aufnahme 14 für zwei Bauteile 28. Es sind ferner Positioniergestaltungen 18 vorgesehen, die hier als pyramidenförmige Vorsprünge ausgebildet sind.

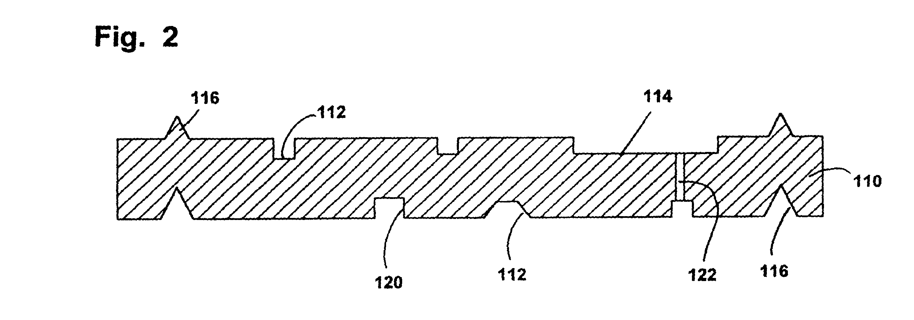

Nachfolgend wird die Herstellung der Einzellagen anhand der Figuren 2 bis 5 beschrieben. In einem ersten Schritt wird ein Einzellagen-Rohling 110 in einem thermoplastischen Abformverfahren aus einem geeigneten Kunststoffmaterial hergestellt. Es kann beispielsweise PMMI verwendet werden, welches optisch transparent ist. Geeignete Materialien sind auch für die Galvanik vorbereitete LCP-Typen, beispielsweise Vectra E820i. Das zum Abformen des Einzellagen-Rohlings 110 verwendete Abformwerkzeug kann ausgehend von einem Masterteil hergestellt werden, das beispielsweise durch Präzisionsfräsen oder durch die sogenannte Dicke-Photolack-Technik mit Laserdirektstrukturierung erzeugt wird. Dieses Masterteil entspricht in seinen Abmessungen und seiner Geometrie exakt dem später herzustellenden Rohling, wobei die geometrischen Mikrostrukturen mit sehr hoher Genauigkeit erzeugt werden können. Ausgehend von dem Masterteil kann durch galvanisches Umformen und, falls gewünscht, galvanisches Umkopieren ein Abformwerkzeug hergestellt werden, welches die später abzuformenden Mikrostrukturen genau wiedergibt.

Der in Figur 2 gezeigte, von einem solchen Abformwerkzeug abgeformte Einzellagen-Rohling 110 weist bereits beispielsweise Leitergraben-Vorformen 112, eine Aufnahme-Vorform 114 sowie Positioniergestaltungs-Vorformen 16, hier in der Form von Vertiefungen oder Vorsprüngen. Es ist auch eine Kühlnut-Vorform 120 vorgesehen, deren Funktion später beschrieben wird.

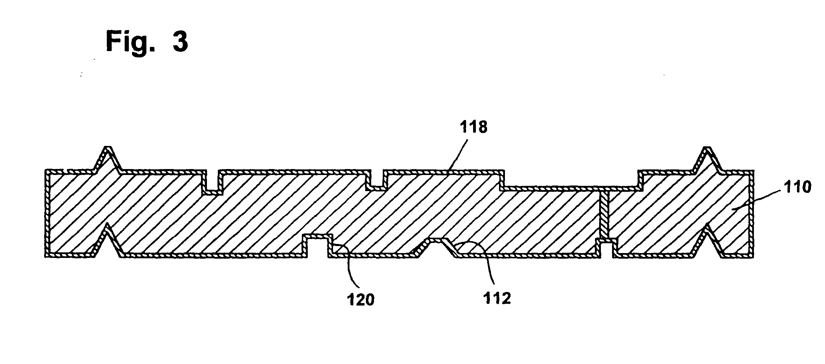

In einem zweiten Schritt wird eine Vorbehandlung der gesamten Oberfläche der Einzellage vorgenommen, um eine dünne Vor-Metallisierung 118 aufzubringen (siehe Figur 3). Die Vor-Metallisierung kann entweder durch ein physikalisches Verfahren, insbesondere Aufdampfen, oder ein chemisches Verfahren erzielt werden, bei dem der Einzellagen-Rohling 110 zunächst bekeimt wird, indem er erst in eine geeignete Lösung, beispielsweise eine Palladiumsalz-Lösung, und anschließend in ein Metallisierungsbad eingetaucht wird.

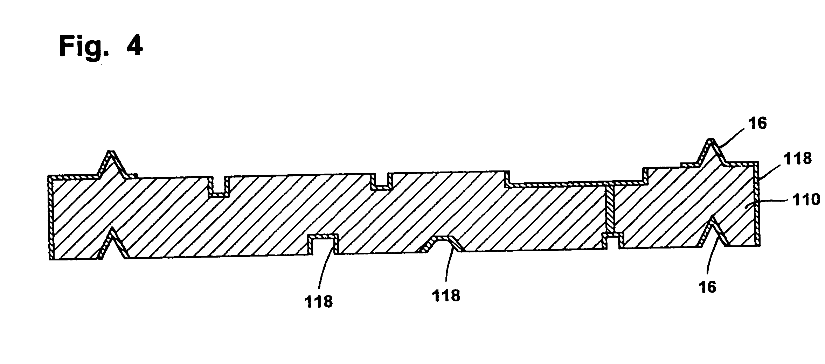

Die so erhaltene Vor-Metallisierung muß später noch galvanisch verstärkt werden, damit sich eine Schichtdicke einstellt, die beispielsweise für die elektrische Leitung ausreichend ist. Um zu gewährleisten, daß auf diese Weise nur eine Metallisierung in den Bereichen erhalten wird, in denen sie tatsächlich erwünscht ist, wird in einem Nachbehandlungsschritt die Vor-Metallisierung in den Bereichen entfernt, in denen später keine Metallisierung vorhanden sein soll. Da alle Bereiche der beiden Funktionsseiten der Einzellage, die später mit einer Metallisierung versehen werden sollen, gegenüber der Oberfläche der Einzellage vertieft ausgebildet sind, beispielsweise als Leitergraben oder als vertiefte Aufnahme, kann die Vor-Metallisierung beispielsweise mechanisch durch Bürsten oder Schleifen der gesamten Funktionsseite des Einzellagen-Rohlings entfernt werden. Dies ist in Figur 4 zu sehen; die gesamte Unterseite des Einzellagen-Rohlings 110 wurde gebürstet, so daß die Vor-Metallisierung nur in den Leitergraben-Vorformen 112 verblieben ist. Auf der Oberseite des Einzellagen-Rohlings ist ein vollständiges Bürsten nicht möglich, da dort die als Vorsprung ausgebildeten Positioniergestaltungs-Vorformen 116 vorliegen. Aus diesem Grunde wird die Vor-Metallisierung hier nur in einem Bereich zwischen den Positionier-Vorformen 116 abgeschliffen (siehe auf Figur 1).

Alternativ zum mechanischen Abtragen der Vor-Metallisierung kann auch eine chemische Nachbehandlung erfolgen. Beispielsweise kann die Vor-Metallisierung in den Bereichen, in denen später keine Metallisierung gewünscht ist, weggeätzt werden. Besonders wenig Material muß abgetragen werden, wenn im Falle einer chemisch aufzutragenden Vor-Metallisierung die Nachbehandlung bereits nach dem Bekeimen der Oberfläche erfolgt, also bevor noch die eigentliche Vor-Metallisierung aufgebracht ist. In diesem Fall muß lediglich die durch die Bekeimung erzielte, besonders dünne Materialschicht abgetragen werden.

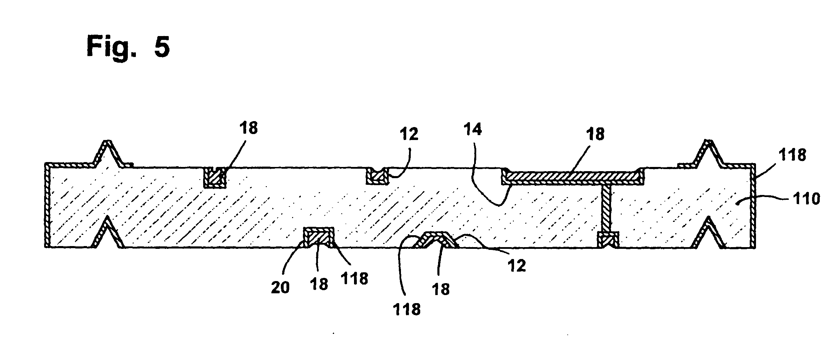

Anschließend wird die Vor-Metallisierung galvanisch verstärkt. Dabei kann durch gezieltes Anlegen unterschiedlicher Spannungen eine unterschiedliche Dicke der Metallisierung erzielt werden. Die fertige Einzellage mit Bereichen unterschiedlich dicker Metallisierung ist in Figur 5 zu sehen. Galvanisch nicht verstärkt wurde die Vor-Metallisierung an den Stirnseiten der Einzellage 10 sowie im Bereich der Positioniergestaltungen 16. Die Metallisierung 18 im Bereich des trapezförmigen Leitergrabens 12 auf der Unterseite der Einzellage ist mit einer mittleren Dicke ausgeführt. Dagegen ist die Metallisierung 18 der auf der Unterseite angeordneten Kühlnut 20 mit besonders großer Dicke ausgeführt, so daß die Abfuhr von Verlustwärme eines an der Leiterplatte angeordneten Bauteils durch Wärmeleitung möglich ist.

Anstelle der Kühlnut kann auch ein Wärmeleitblech verwendet werden, das separat hergestellt wird, beispielsweise durch Ausstanzen eines Kupferblechs, und in eine Aussparung einer Einzellage eingesetzt und dort verklebt wird, beispielsweise durch einen Leitkleber. Hier kommt es nicht so sehr auf die präzise Justierung des Kühlbleches an; wesentlich ist, daß es sich mit der entsprechenden Einzellage in einer gut wärmeleitenden Verbindung befindet.

Die Vor-Metallisierung im Bereich der Positioniergestaltungen kann entweder, wie dies in Figur 5 gezeigt ist, auf der Einzellage 10 verbleiben, wobei dann bei der Bemessung der Positioniergestaltungen 16 die Dicke der Vor-Metallisierung berücksichtigt werden muß, damit die Einzellagen 10 später in der gewünschten Weise relativ zueinander positioniert sind, insbesondere hinsichtlich ihres Abstandes voneinander. Die Vor-Metallisierung kann im Bereich der Positioniergestaltungen auch entfernt werden, nachdem die eigentliche Metallisierung durch galvanisches Verstärken aufgebracht ist, indem die gesamte Einzellage kurz in ein Säurebad eingetaucht wird. Dabei wird die Vor-Metallisierung aufgrund ihrer geringen Dicke schnell entfernt, während die dickere eigentliche Metallisierung nur unwesentlich unter dem Säureangriff leidet. Auf diese Weise sind die Positioniergestaltungen wieder freigelegt, so daß die sich bei der Vorbehandlung des Einzellagen-Rohlings einstellende Dicke der Vor-Metallisierung keinen Einfluß auf die spätere Positionierung hat.

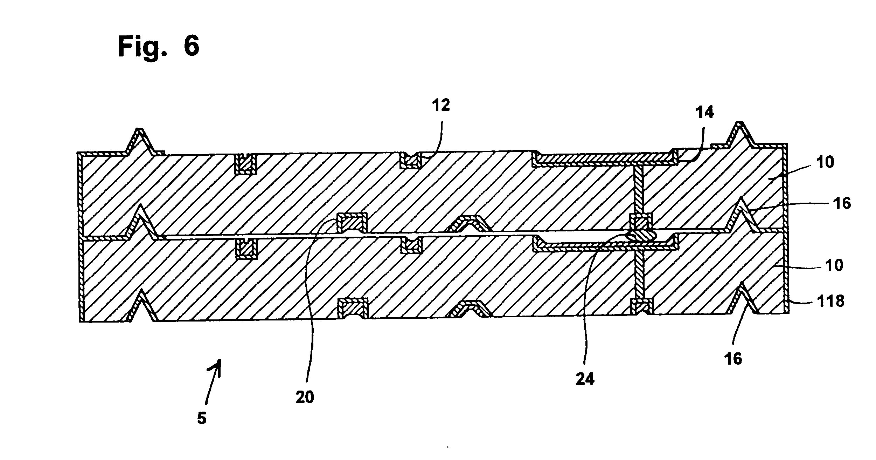

In Figur 6 ist ein Ausführungsbeispiel einer Leiterplatte gezeigt, die aus zwei aufeinandergesetzten Einzellagen besteht. Die beiden Einzellagen werden durch Eingreifen der Vorsprünge 16, die auf der Oberseite der unteren Einzellage ausgebildet sind, in die Vertiefungen 16 positioniert, die auf der Unterseite der oberen Einzellage ausgebildet sind. Selbstverständlich können auf diese Weise mehr als zwei Einzellagen übereinander angeordnet werden, so daß eine aus einer Vielzahl von Einzellagen bestehende Leiterplatte gebildet ist. Die beschriebenen Ausführungsbeispiele weisen nur aus Gründen der besseren Übersichtlichkeit jeweils zwei Einzellagen auf.

Ein wichtiger Gesichtspunkt bei der beschriebenen Positionierung der Einzellagen relativ zueinander besteht darin, daß es sich um eine passive Positionierung handelt, bei der sich also die präzise Ausrichtung der Einzellagen zueinander automatisch beim Aufsetzen der einen Einzellage auf die andere ergibt.

Um eine elektrische Kontaktierung zwischen verschiedenen Funktionsseiten der Einzellagen zu ermöglichen, sind bei dem in Figur 6 gezeigten Ausführungsbeispiel die Einzellagen 10 jeweils mit einer Kontaktöffnung 22 versehen, die bereits im Einzellagen-Rohling 110 als Kontaktöffnungs-Vorform 122 ausgebildet ist. Auch die Kontaktöffnungs-Vorform 122 wird bei der Vor-Metallisierung und anschließenden galvanischen Verstärkung metallisiert, so daß eine elektrisch leitende Verbindung zwischen den beiden Funktionsseiten der Einzellage 10 erzielt wird. Beim Montieren der Einzellagen aneinander wird im Bereich der Kontaktöffnung 22 ein elektrisch leitfähiger Klebstoff 24 verwendet, so daß durch Leitkleben die gewünschte elektrische Verbindung erzielt wird. Alternativ könnte eine Lotpaste verwendet werden.

Gemäß einer nicht dargestellten Weiterbildung könnte die Kontaktöffnung 22 auch mit einem solchen Durchmesser ausgeführt und die dort abgeschiedene Metallisierung mit einer solchen Wandstärke ausgebildet werden, daß ähnlich wie die Wirkung der Kühlnut eine Wärmeabfuhr durch Wärmeleitung zwischen den beiden Funktionsseiten einer Einzellage möglich ist.

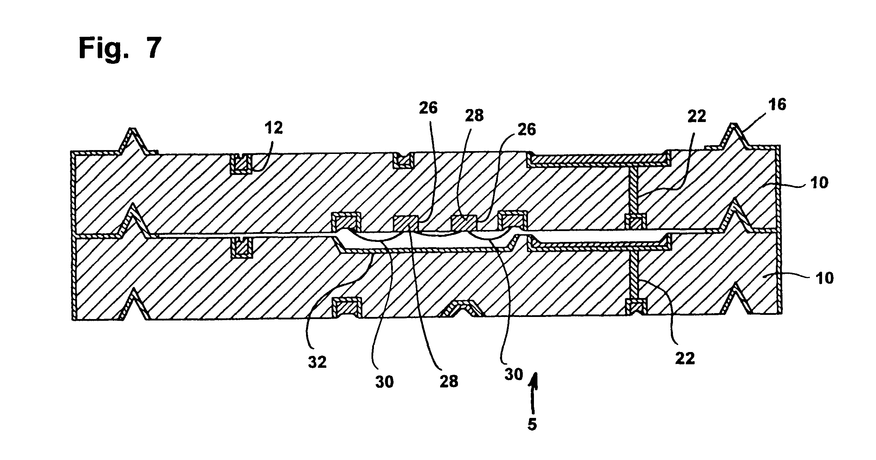

In Figur 7 ist ein weiteres Ausführungsbeispiel einer Leiterplatte gezeigt. Hier ist die obere der beiden Einzellagen 10 auf ihrer Unterseite mit zwei Aufnahmen 26 versehen, in welchen jeweils ein elektronisches, optisches oder opto-elektronisches Bauteil 28 angeordnet ist. Die Bauteile 28 stehen nicht über die Oberfläche der entsprechenden Einzellage hervor, da sie vollständig in der Aufnahme 26 angeordnet sind. Zum Schutz von Bonddrähten 30, mittels denen die Bauteile 28 an die Metallisierung 18 in den Leitergräben 12 angeschlossen sind, ist die untere Einzellage 10 gegenüber den Bauteilen mit einer Aussparung 32 versehen.

Da die Mikrostrukturen zur Aufnahme der Bauteile 28 bei der Herstellung der Einzellagen 10 durch Abformen eines geeignet strukturierten Abformwerkzeuges erhalten werden, ist jede Aufnahme 26 sehr präzise ausgebildet, so daß beispielsweise für optische Anwendungen oder für HF-Anwendungen eine hohe Positionsgenauigkeit des eingesetzten Bauteils relativ zu benachbarten multifunktionalen Strukturen realisierbar ist. Es können grundsätzlich Bauteile auf jeder Vorfertigungsebene eingesetzt werden; besonders vorteilhaft ist die Verwendung von nackten Chips oder Dies, weil hier durch den Wegfall des üblichen Leadframe-Gehäuses die Packungsdichte erhöht werden kann. Die Integration von Bauteilen zwischen den Einzellagen reduziert im Vergleich zu konventionellen Mehrlagenleiterplatten den Verdrahtungsaufwand, da die Bauteile lateral und vertikal, also in verschiedenen Ebenen, näher an ihrem Zielpunkt eingesetzt werden können. Dadurch steigt die Packungsdichte, so daß die Baugröße abnimmt.

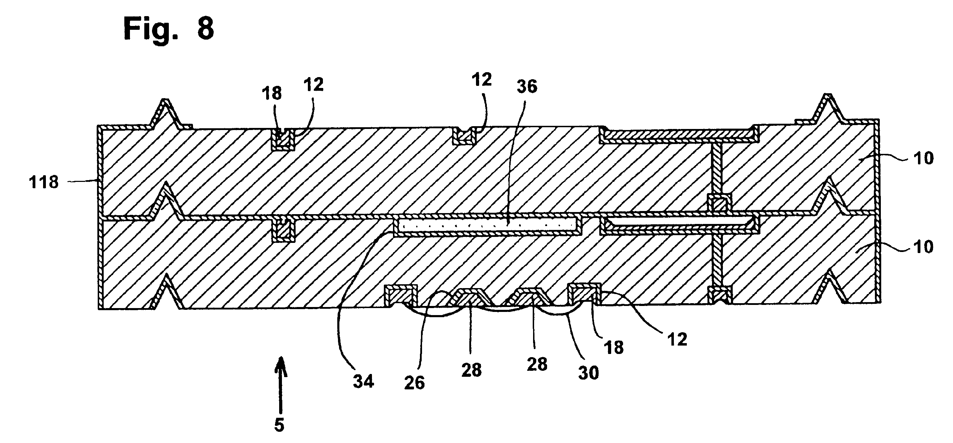

In Figur 8 ist ein Ausführungsbeispiel dargestellt, bei dem auf der Oberseite der unteren Einzellage ein Kühlkanal 34 vorgesehen ist, der zur aktiven Kühlung der Leiterplatte verwendet werden kann. Auch der Kühlkanal 35 ist auf seiner Innenseite, ähnlich wie ein Leitergraben, mit einer Metallisierung versehen; diese Metallisierung schützt das Material der Einzellage vor dem Kühlmittel.

Die Metallisierung auf der Unterseite der oberen Einzellage 10 ist bei dem gezeigten Ausführungsbeispiel durchgehend, so daß sie auf der Oberseite der unteren Einzellage 10 aufliegt und den Kühlkanal 34 abschließt. Somit kann durch den Kühlkanal 34 ein Kühlmittel 36, beispielsweise Wasser, geleitet werden, wodurch auch große Verlustwärmemengen von Bauteilen 28 abgeführt werden können, die der Kühlnut gegenüberliegend auf der Unterseite der unteren Einzellage angebracht sind.

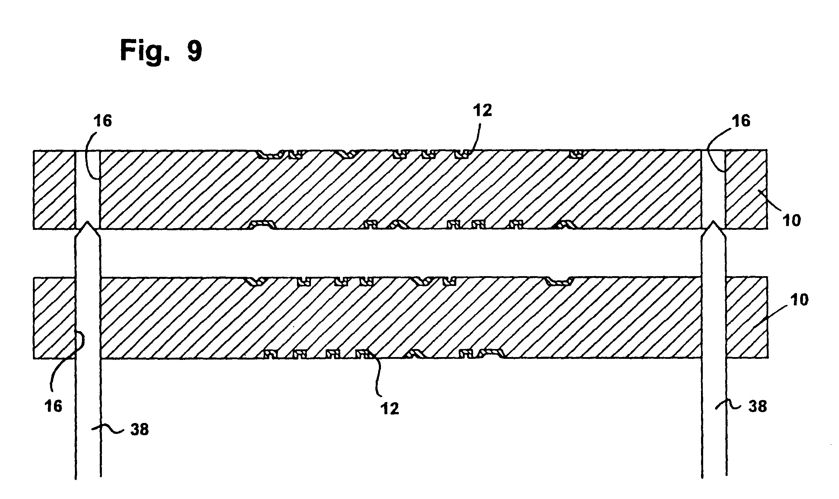

In Figur 9 ist ein weiteres Ausführungsbeispiel einer Leiterplatte gezeigt. Im Unterschied zu den vorangegangenen Ausführungsbeispielen werden hier als Positioniergestaltungen 16 keine Vorsprünge und Vertiefungen verwendet, sondern mehrere Öffnungen 16, die sich durch die jeweilige Einzellage hindurch von einer Funktionsseite zur anderen erstreckt. Auch die Öffnungen 16 werden beim Abformen der Einzellagen ausgebildet, so daß sie mit der gewünschten Präzision und der erforderlichen genauen Ausrichtung zu anderen geometrischen Strukturen der Einzellage angeordnet werden.

Zur Positionierung der Einzellagen relativ zueinander werden Positionierstifte 38 verwendet, die in die Öffnungen 16 eingeschoben werden und, da sie an ihrer Spitze konisch zulaufen, für die passive Ausrichtung der Einzellagen relativ zueinander sorgen.

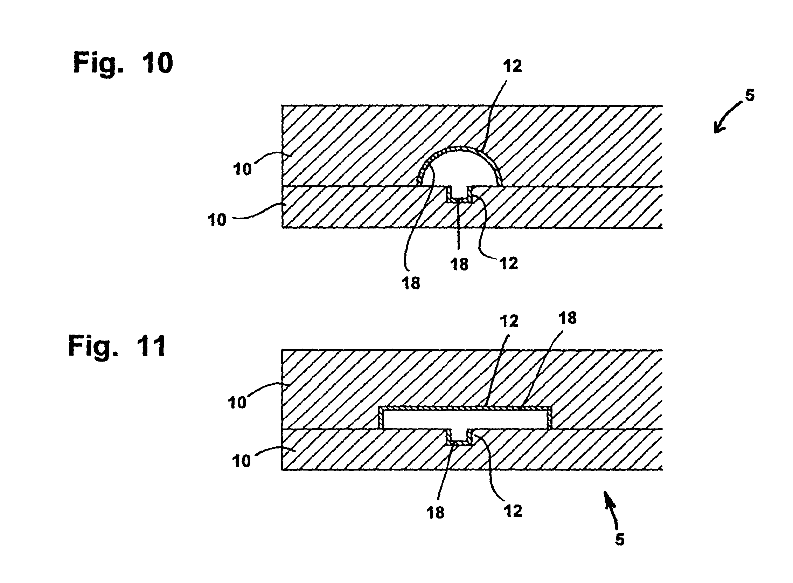

In Figur 10 ist ein Detail einer aus zwei Einzellagen 10 bestehenden Leiterplatte 5 gezeigt, wobei die anhand der vorhergehenden Ausführungsbeispiele beschriebenen Merkmale wie Positioniergestaltungen oder Kühlkanäle hier im Hinblick auf eine übersichtliche Darstellung nicht gezeigt sind.

Die untere Einzellage weist einen Leitergraben 12 auf, der einen rechteckigen Querschnitt hat. Diesem Leitergraben 12 gegenüberliegend ist auf der oberen Einzellage ein weiterer Leitergraben 12 ausgebildet, der einen halbkreisförmigen Querschnitt hat. Die beiden Leitergräben sind an den Einzellagen so ausgebildet, daß sie sich zentriert gegenüberliegen, wobei die Abmessungen des oberen, halbkreisförmigen Leitergrabens größer sind als die Abmessungen des unteren Leitergrabens. Somit überspannt der obere Leitergraben 12 den unteren Leitergraben, wobei der Raum zwischen den Leitergräben mit Luft gefüllt ist. Die beiden metallisierten Leitergräben bilden zusammen einen "halbierten" Koaxialleiter, wobei das elektrische und magnetische Wechselfeld im umschlossenen, mit Luft gefüllten Hohlraum geführt wird, so daß die Materialeigenschaften des Kunststoffes der Einzellagen 10 keine Rolle spielen.

Der Leitergraben mit halbkreisförmigem Querschnitt kann analog der oben beschriebenen Vorgehensweise durch Metallisieren und Polieren hergestellt werden. Die erforderliche präzise Positionierung der beiden Leitergräben relativ zueinander wird durch die beschriebenen Positioniergestaltungen erzielt.

In Figur 11 ist eine Alternative zu der in Figur 10 gezeigten Gestaltung dargestellt. Anstelle des halbkreisförmigen Querschnittes für den oberen Leitergraben wird hier ein langgezogener rechteckiger Querschnitt verwendet; die Breite des oberen Leitergrabens beträgt ein Vielfaches der Breite des unteren Leitergrabens. Der obere Leitergraben bildet einen sich "himmelartig" über dem Mittelleiter erstreckenden Rückleiter; die Ausrichtung der beiden Leitergräben zueinander ist bei dieser Ausgestaltung sehr viel weniger kritisch. Nach wie vor werden aber hohe Anforderungen an den Abstand zwischen den beiden Leitergräben gestellt; dieser Abstand muß präzise eingehalten werden.

Zur Ein- und Auskopplung von HF-Signalen in die gezeigten HF-Leitungen der Leiterplatte werden HF-Stecker benötigt. Eine Steckerbuchse oder eine an die Steckerbuchse angepaßte Aufnahmeöffnung läßt sich dank der thermoplastischen Herstellungstechnik für die Einzellagen sehr leicht am Rand der Leiterplatte integrieren.

Gemäß einer nicht dargestellten Weiterbildung können in gleicher Weise wie die HF-Leiter auch elektrische Resonatorstrukturen durch metallisierte Vertiefungen einer Einzellage hergestellt werden.

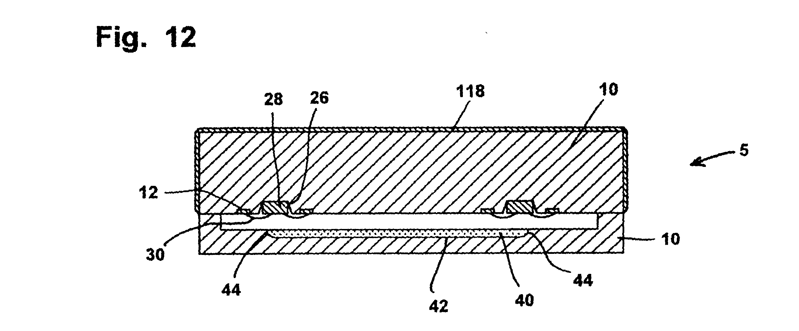

In Figur 12 ist schematisch ein weiteres Ausführungsbeispiel einer Leiterplatte gezeigt. Hier ist die untere Einzellage 10 mit einem Wellenleiter 40 versehen, der gebildet ist durch einen Wellenleitergraben 42, der mit einem geeigneten, optisch transparenten Material gefüllt ist. Der Wellenleitergraben 42 wird ähnlich wie die Leitergraben-Vorformen bereits beim Abformen des Einzellagen-Rohlings als Mikrostruktur ausgebildet. Zur Erzielung einer optimalen Wellenleitung muß die untere Einzellage aus einem optisch transparenten Material bestehen. Dies ist der Fall, wenn als Material PMMI verwendet wird.

Der Wellenleitergraben 42 ist an seinen Enden mit reflektierenden Stirnseiten versehen. Der Reflektorbereich ist parabolförmig ausgebildet, so daß im Vergleich mit einem ebenen Reflektor ein verbessertes Einkoppeln erzielt wird. Der Reflektorbereich wird selektiv metallisiert und gegebenenfalls metallisiert, so daß Spiegel 44 gebildet sind. Eine ganzflächige Metallisierung im Bereich des Wellenleitergrabens 42 ist hier nicht möglich, da die optische Wellenleitung durch metallische Grenzflächen zu stark gedämpft würde.

Anschließend wird der Wellenleitergraben 42 in bekannter Weise mit einem flüssigen Kernmaterial gefüllt, welches nach Aushärtung einen höheren Brechungsindex als für das umgebende Material der unteren Einzellage 10 hat. Auf diese Weise ist ein optischer Wellenleiter gebildet.

Die obere Einzellage 10 ist hier ähnlich wie bei einem vorhergehenden Ausführungsbeispiel mit Aufnahmen 26 für opto-elektronische Bauteile 28 versehen. Bei dem in Figur 12 links gezeigten Bauteil 28 kann es sich um ein VCSEL handeln, und bei dem in Figur 12 auf der rechten Seite gezeigten Bauteil kann es sich um ein PD handeln. Über die Spiegel 44 ist nun ein Ein- und Auskoppeln von Signalen der Sende- und Empfangselemente möglich.

Die gezeigte Anordnung stellt hohe Anforderungen an die Ausrichtung der beiden Einzellagen 10 sowie der Anordnung der Bauteile 28 relativ zum Wellenleiter 40 und zu den Spiegeln 44. Bei einem Wellenleiter mit einer Breite von 100 µm ist, um eine gute optische Kopplung zu erreichen, eine Toleranz von nur ca. 20 µm zulässig. Diese Toleranzen können zuverlässig eingehalten werden, wenn sämtliche Strukturen von einem Werkzeug abgeformt werden, das durch galvanisches Umkopieren eines Masterteils hergestellt wird, das im Röntgenlithographieverfahren bearbeitet wurde.

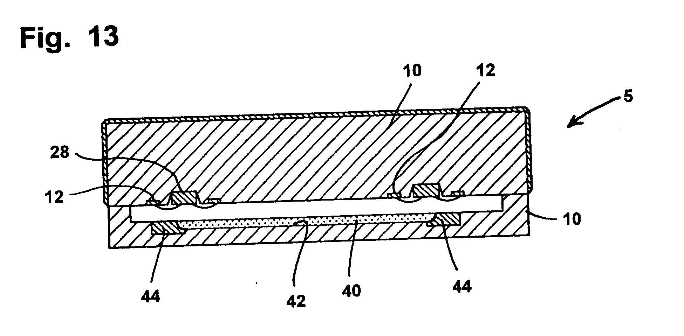

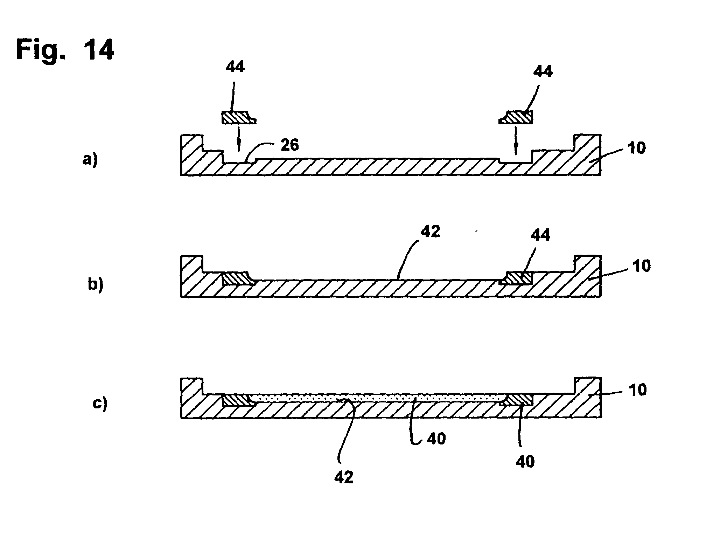

In Figur 13 ist eine Variante zu dem in Figur 12 gezeigten Ausführungsbeispiel dargestellt. Anstelle der in Figur 12 verwendeten parabolförmigen Stirnflächen des Wellenleitergrabens, mittels denen das Ein-/Auskoppeln der Lichtsignale erzielt wird, werden bei der Variante von Figur 13 nun Spiegel 44 verwendet, die als von der unteren Einzellage 10 getrennte Teile hergestellt werden. Auf diese Weise ist es nicht erforderlich, eine selektive Metallisierung des Reflektorbereiches durchzuführen. Anstatt dessen können vollständig metallisierte Kunststoffplättchen (Siehe Figur 14) mit präzisen Außenabmessungen hergestellt werden, welche analog den die Bauteile 28 bildenden Halbleiterchips der oberen Einzellage in geeignete Aussparungen der unteren Einzellage an den Enden des Wellenleitergrabens 42 eingesetzt werden. Die Spiegel liegen dabei mit einer Nase unterhalb des Wellenleitergrabens, so daß sie, wenn der Wellenleiter 40 gebildet ist, von diesem fest in der Einzellage gehalten werden.

Über den gezeigten Wellenleiter 40 hinaus können auch andere integriertoptische Strukturen wie optische Leistungsteiler oder optische Sternkoppler in den Einzellagen realisiert werden. Zu diesem Zweck wird beim Abformen eine geeignet gestaltete Nut in der entsprechenden Einzellage ausgebildet. Diese wird anschließend mit einem geeigneten, optisch transparenten Material ausgefüllt. Die Wellenleiter können auch bis zum Rand der Leiterplatte geführt werden, so daß dort durch geeignete dreidimensionale Strukturen ein Stecker angeschlossen werden kann, so daß beispielsweise eine Lichtleitfaser mit der Leiterplatte verbunden werden kann.

Die Leiterplatte kann auch mit einer geeignet strukturierten Nut, vergleichbar derjenigen zur Herstellung des Wellenleiters, versehen werden, in die direkt eine Lichtleitfaser eingelegt wird. Auf diese Weise kann Licht unmittelbar in einen sich an die Lichtleitfaser anschließenden Wellenleiter oder in ein opto-elektronisches Bauteil eingekoppelt werden.

Ein besonderer Vorteil der beschriebenen Leiterplatte besteht darin, daß durch das verwendete Metallisierungsverfahren elektrische Leiter mit Strukturbreiten von ca. 5 µm hergestellt werden können. Durch die damit möglichen engen Leiterbahnen (bei herkömmlichen Leiterplatten sind Strukturbreiten von ca. 50 µm Stand der Technik) steigt die Packungsdichte, und die Baugröße nimmt ab.

Ein weiteres wichtiges Merkmal bei den beschriebenen Leiterplatten besteht darin, daß jede Einzellage für sich separat elektrisch getestet werden kann. Es werden also nur solche Einzellagen zur Leiterplatte montiert, welche einen Funktionstest bestanden haben. Dabei ergibt sich bei der Herstellung der Leiterplatte ein besonders geringer Ausschuß, der gegenüber Verfahren aus dem Stand der Technik drastisch reduziert ist.

### Bezugszeichenliste:

- 5:: Leiterplatte
- 10:: Einzellage
- 12:: Leitergraben
- 14:: Aufnahme
- 16:: Positioniergestaltung
- 18:: Metallisierung
- 20:: Kühlnut
- 22:: Kontaktöffnung
- 24:: Elektrisch leitfähiger Klebstoff
- 26:: Aufnahme
- 28:: Bauteil
- 30:: Bonddraht
- 32:: Aussparung
- 34:: Kühlkanal
- 36:: Kühlmittel
- 38:: Positionierstift
- 40:: Wellenleiter
- 42:: Wellenleitergraben
- 44:: Spiegel
- 110:: Einzellagen-Rohling
- 112:: Leitergraben-Vorform
- 114:: Aufnahme-Vorform
- 116:: Positioniergestaltungs-Vorform
- 118:: Vor-Metallisierung
- 120:: Kühlnut-Vorform
- 122:: Kontaktöffnungs-Vorform

## Patentansprüche

1. Leiterplatte (5) bestehend aus mindestens zwei in Abformtechnik hergestellten Leiterplatten-Einzellagen (10) aus Kunststoff, die jeweils eine erste und eine zweite Funktionsseite aufweisen sowie mindestens eine mikrostrukturierte Positioniergestaltung (16) auf der ersten und auf der zweiten Funktionsseite und mindestens einen mikrostrukturierten, mit einer Metallisierung (18) versehenen Leitergraben (12) auf einer der Funktionsseiten.

2. Leiterplatte nach Anspruch 1, **dadurch gekennzeichnet, daß** die Positioniergestaltung (16) ein Vorsprung ist.

3. Leiterplatte nach Anspruch 2, **dadurch gekennzeichnet, daß** der Vorsprung (16) pyramidenförmig ist.

4. Leiterplatte nach Anspruch 1, **dadurch gekennzeichnet, daß** die Positioniergestaltung (16) eine Vertiefung ist.

5. Leiterplatte nach Anspruch 4, **dadurch gekennzeichnet, daß** die Vertiefung (16) komplementär zur einem pyramidenförmigen Vorsprung ist.

6. Leiterplatte nach Anspruch 2 und Anspruch 4, **dadurch gekennzeichnet, daß** jede Einzellage auf einer Funktionsseite mit mehreren Vorsprüngen (16) und auf der anderen Funktionsseite mit mehreren Vertiefungen (16) versehen ist, wobei die Vorsprünge der einen Einzellage in die Vertiefungen der anderen Einzellage eingreifen, so daß die beiden Einzellagen relativ zueinander präzise positioniert sind.

7. Leiterplatte nach Anspruch 1, **dadurch gekennzeichnet, daß** die Positioniergestaltung eine Öffnung (16) ist, die sich von der einen Funktionsseite durch die Einzellage (10) hindurch bis auf die andere Funktionsseite erstreckt.

8. Leiterplatte nach Anspruch 7, **dadurch gekennzeichnet, daß** ein Positionierstift (38) vorgesehen ist, der sich durch die Öffnungen (16) der Einzellagen (10) hindurch erstreckt, so daß die beiden Einzellagen relativ zueinander präzise positioniert sind.

9. Leiterplatte nach einem der vorhergehenden Ansprüche, **dadurch gekennzeichnet, daß** der Leitergraben (12) sich bis zum Rand der Leiterplatte erstreckt, so daß ein Steckverbinder angeschlossen werden kann.

10. Leiterplatte nach einem der vorhergehenden Ansprüche, **dadurch gekennzeichnet, daß** der Leitergraben (12) einen halbkreisförmigen Querschnitt hat.

11. Leiterplatte nach einem der Ansprüche 1 bis 9, **dadurch gekennzeichnet, daß** der Leitergraben (12) einen rechteckigen Querschnitt hat.

12. Leiterplatte nach einem der Ansprüche 10 und 11, **dadurch gekennzeichnet, daß** ein ersten Leitergraben (12) auf einer der Einzellagen (10) und ein zweiter Leitergraben (12) auf der anderen Einzellage (10) vorgesehen ist und daß die beiden Leitergräben einander zentriert gegenüberliegen, wobei einer der Leitergräben kleinere Abmessungen hat als der andere Leitergraben.

13. Leiterplatte nach Anspruch 12, **dadurch gekennzeichnet, daß** sich die beiden Leitergräben (12) bis zum Rand der Leiterplatte (5) erstrecken und ein Steckanschluß für eine HF-Leitung vorgesehen ist.

14. Leiterplatte nach einem der Ansprüche 12 und 13, **dadurch gekennzeichnet, daß** der Raum zwischen den einander gegenüberliegenden Leitergräben (12) mit Luft gefüllt ist.

15. Leiterplatte nach einem der vorhergehenden Ansprüche, **dadurch gekennzeichnet, daß** auf mindestens einer der Einzellagen eine Kühlnut (20) vorgesehen ist, die mit einer Metallisierung (18) solcher Dicke gefüllt ist, daß ein Kühlkörper gebildet ist.

16. Leiterplatte nach einem der vorhergehenden Ansprüche, **dadurch gekennzeichnet, daß** auf mindestens einer der Einzellagen ein Kühlkanal (34) vorgesehen ist, durch den ein Kühlmittel (36) geleitet werden kann, und daß die andere Einzellage den Kühlkanal abdeckt.

17. Leiterplatte nach Anspruch 16, **dadurch gekennzeichnet, daß** sich der Kühlkanal bis zum Rand der Leiterplatte (5) erstreckt und ein Kühlmittel-Anschluß gebildet ist.

18. Leiterplatte nach einem der vorhergehenden Ansprüche, **dadurch gekennzeichnet, daß** in mindestens einer der Einzellagen mindestens eine Aufnahme (26) für ein elektronisches, optisches oder opto-elektronisches Bauteil (28) vorgesehen ist.

19. Leiterplatte nach Anspruch 18, **dadurch gekennzeichnet, daß** in der anderen Einzellage eine Aussparung (32) vorgesehen ist, die der Aufnahme gegenüberliegt.

20. Leiterplatte nach einem der vorhergehenden Ansprüche, **dadurch gekennzeichnet, daß** die beiden Einzellagen miteinander durch ein elektrisch leitendes Material (24) verbunden sind.

21. Leiterplatte nach Anspruch 20, **dadurch gekennzeichnet, daß** in mindestens einer der Einzellagen (10) eine Kontaktöffnung (22) vorgesehen ist, die sich von der ersten Funktionsseite durch die Einzellage (10) hindurch zu deren zweiter Funktionsseite erstreckt, und daß die Kontaktöffnung (22) mit einem elektrisch leitenden Material gefüllt ist.

22. Leiterplatte nach einem der vorhergehenden Ansprüche, **dadurch gekennzeichnet, daß** mindestens eine der Einzellagen aus einem optisch transparenten Material besteht und daß auf dieser Einzellage ein Wellenleitergraben (42) vorgesehen ist, der mit einem optisch transparenten Material gefüllt ist, dessen Brechungsindex sich geeignet von demjenigen des Materials der Einzellage (10) unterscheidet, so daß ein Wellenleiter (40) gebildet ist.

23. Leiterplatte nach Anspruch 22, **dadurch gekennzeichnet, daß** die mit dem Wellenleiter (40) versehene Einzellage einen Spiegel (44) aufweist, mittels dem Licht in den Wellenleiter eingekoppelt und aus diesem ausgekoppelt werden kann.

24. Leiterplatte nach Anspruch 23, **dadurch gekennzeichnet, daß** der Spiegel (44) ein separates Bauteil ist, das in die Einzellage eingesetzt wird.

25. Verfahren zum Herstellen einer Leiterplatte (5), insbesondere nach einem der vorhergehenden Ansprüche, mittels der folgenden Schritte:
- es werden in Abformtechnik mindestens zwei Einzellagen-Rohlinge (110) hergestellt, die jeweils auf einer ersten und einer zweiten Funktionsseite mit Positioniergestaltungs-Vorformen (116) versehen sind;
- die Einzellagen-Rohlinge (110) werden auf ihrer gesamten Oberfläche so vorbehandelt, daß sie mit einer Metallisierung versehen werden können;
- die Oberfläche wird in den Bereichen, die nicht mit einer Metallisierung versehen werden sollen, nachbehandelt, so daß sich in diesen Bereichen keine Metallisierung abscheidet;
- auf die nicht nachbehandelten Bereiche wird eine Metallisierung (18) aufgebracht;
- die Einzellagen-Rohlinge werden aufeinandergesetzt, wobei sie mittels der Positioniergestaltungen (16) relativ zueinander präzise positioniert werden.

26. Verfahren nach Anspruch 25, **dadurch gekennzeichnet, daß** die Vorbehandlung darin besteht, eine dünne Vor-Metallisierung (118) aufzubringen.

27. Verfahren nach Anspruch 26, **dadurch gekennzeichnet, daß** die Nachbehandlung darin besteht, die Vor-Metallisierung (118) mechanisch abzutragen.

28. Verfahren nach Anspruch 25, **dadurch gekennzeichnet, daß** die Vorbehandlung darin besteht, das Substrat zu bekeimen.

29. Verfahren nach Anspruch 28, **dadurch gekennzeichnet, daß** die Nachbehandlung darin besteht, die Bekeimung chemisch zu entfernen.

30. Verfahren nach einem der Ansprüche 25 bis 29, **dadurch gekennzeichnet, daß** die Einzellagen (10) spritzgegossen werden.
